# EUROPEAN PATENT APPLICATION

(11) **EP 4 836 631 A1**
(43) Date of publication of application: **04.11.2026**
(21) Application number: 24923444.4
(22) Date of filing: 12.11.2024
(51) Int. Cl.: H10D 30/67, H10D 64/68, H01L 21/34

(54) **CHIP AND MANUFACTURING METHOD THEREFOR, AND ELECTRONIC DEVICE**

(30) Priority: 07.02.2024 CN 202410174392
(71) Applicant: Huawei Technologies Co., Ltd., Shenzhen, Guangdong 518129 (CN)
(72) Inventor: KANG, Lu, Shenzhen, Guangdong 518129 (CN); WU, Ying, Shenzhen, Guangdong 518129 (CN); LU, Shiheng, Shenzhen, Guangdong 518129 (CN); WANG, Heng, Shenzhen, Guangdong 518129 (CN); XU, Jeffrey Junhao, Shenzhen, Guangdong 518129 (CN)
(74) Representative: Huawei European IPR
(86) International application number: PCT/CN2024/131589
(87) International publication number: WO 2025/167240

(57) **Abstract**

This application relates to the field of semiconductor technologies, and provides a chip and a fabrication method therefor, and an electronic device, to suppress, by using a first gate dielectric layer, a positive drift component of a threshold voltage without compromising gate controllability, so as to alleviate BTI of a transistor. The chip includes a transistor, and the transistor includes a channel layer, a first gate dielectric layer, a second gate dielectric layer, and a gate that are sequentially stacked. A material of the channel layer includes an oxide semiconductor, and the channel layer is in contact with the first gate dielectric layer. A defect concentration of a material of the first gate dielectric layer is lower than a defect concentration of a material of the second gate dielectric layer, and a dielectric constant of the material of the second gate dielectric layer is greater than a dielectric constant of the material of the first gate dielectric layer.

## Description

This application claims priority to Chinese Patent Application No. 202410174392.7, filed with the China National Intellectual Property Administration on February 7, 2024 and entitled "CHIP AND FABRICATION METHOD THEREFOR, AND ELECTRONIC DEVICE", which is incorporated herein by reference in its entirety.

### TECHNICAL FIELD

This application relates to the field of semiconductor technologies, and in particular, to a chip and a fabrication method therefor, and an electronic device.

### BACKGROUND

With the development of advanced integrated circuit technologies, new transistors can be fabricated in a back-end-of-line process, which is an effective approach to achieving chip miniaturization and improving chip performance. An oxide semiconductor transistor with a channel layer including an oxide semiconductor has advantages such as a low leakage current, high mobility, a high on/off ratio, a low processing temperature, and easy back-end-of-line integration, and therefore becomes one of the candidates for next-generation transistor technologies.

However, reliability issues represented by bias-temperature instability (bias-temperature instability, BTI) remain a main problem for the oxide semiconductor transistor.

### SUMMARY

To resolve the foregoing technical problem, this application provides a chip and a fabrication method therefor, and an electronic device, to suppress, by using a first gate dielectric layer, a positive drift component of a threshold voltage without compromising gate controllability, so as to alleviate BTI of a transistor.

According to a first aspect, this application provides a chip. The chip includes a transistor, and the transistor includes a channel layer, a first gate dielectric layer, a second gate dielectric layer, and a gate that are sequentially stacked. A material of the channel layer includes an oxide semiconductor, and the channel layer is in contact with the first gate dielectric layer. A defect concentration of a material of the first gate dielectric layer is lower than a defect concentration of a material of the second gate dielectric layer, and a dielectric constant of the material of the second gate dielectric layer is greater than a dielectric constant of the material of the first gate dielectric layer.

In this application, in one aspect, the channel layer is in contact with the first gate dielectric layer, and a defect concentration of a material of the first gate dielectric layer is lower than a defect concentration of a material of the second gate dielectric layer, that is, a quantity of defects of the first gate dielectric layer is lower than a quantity of defects of the second gate dielectric layer, to suppress a positive drift component of a threshold voltage by using the first gate dielectric layer, so as to alleviate BTI of the transistor. In another aspect, in addition to the first gate dielectric layer, the second gate dielectric layer in contact with the gate is further included in this embodiment of this application, and a dielectric constant of the material of the second gate dielectric layer is greater than a dielectric constant of the material of the first gate dielectric layer, to ensure gate controllability of the gate by using the second gate dielectric layer.

In some possible implementations, a difference between a defect energy level of the material of the first gate dielectric layer and a conduction band electron of the channel layer may be further greater than a difference between a defect energy level of the material of the second gate dielectric layer and the conduction band electron of the channel layer, to suppress the positive drift component of the threshold voltage by using the first gate dielectric layer, so as to alleviate the BTI of the transistor; and/or, hydrogen content in the material of the first gate dielectric layer is lower than hydrogen content in the material of the second gate dielectric layer, and because the content of the hydrogen in the first gate dielectric layer is relatively small, only a small amount of hydrogen in the first gate dielectric layer in contact with the channel layer enters the channel layer as a donor, and is doped with electrons in the channel layer, thereby effectively suppressing a negative drift component of the threshold voltage and alleviating the BTI of the transistor.

The content of the hydrogen in the material of the first gate dielectric layer is not limited in this application, provided that the content of the hydrogen in the material of the first gate dielectric layer is lower than the content of the hydrogen in the material of the second gate dielectric layer. Optionally, the content of the hydrogen in the material of the first gate dielectric layer is less than 1e²⁰ atoms/cc.

Based on the foregoing condition, the material of the first gate dielectric layer includes hafnium aluminum oxide and aluminum oxide; and/or the dielectric constant of the material of the second gate dielectric layer is greater than 15. For example, the material of the second gate dielectric layer includes at least one of lanthanum oxide and hafnium dioxide.

In some possible implementations, it is considered that the second gate dielectric layer has a high defect concentration, a small difference with the conduction band electron of the channel layer, and a high hydrogen content, that is, the second gate dielectric layer still has a large defect, which may affect the BTI of the transistor. Based on this, in a direction from the first gate dielectric layer to the second gate dielectric layer, a thickness of the first gate dielectric layer may be greater than a thickness of the second gate dielectric layer, so that the first gate dielectric layer has a sufficient thickness to block the second gate dielectric layer, and the second gate dielectric layer is prevented from capturing electrons in the channel layer, thereby alleviating the BTI of the transistor.

For example, the thickness of the first gate dielectric layer may range from 2 nm to 50 nm, and the thickness of the second gate dielectric layer is less than the thickness of the first gate dielectric layer. For example, the thickness of the first gate dielectric layer is 3 nm, and the thickness of the second gate dielectric layer is 2 nm.

In some possible implementations, the chip further includes a substrate, and the transistor is disposed on the substrate. The transistor further includes a first electrode and a second electrode, and both the first electrode and the second electrode are in contact with the channel. The first electrode is a source, and the second electrode is a drain; or the first electrode is a drain, and the second electrode is a source.

For transistors of different structures, the channel layer, the first gate dielectric layer, the second gate dielectric layer, and the gate are stacked at different positions.

For example, the transistor is a bottom-gate transistor. The gate, the second gate dielectric layer, the first gate dielectric layer, and the channel layer are sequentially stacked in a direction from the substrate to the transistor. The transistor further includes a first protective layer. The first protective layer, the first electrode, and the second electrode are all disposed on a side that is of the channel layer and that faces away from the substrate, and the first protective layer is disposed between the channel layer, and the first electrode and the second electrode. The first protective layer includes a first via and a second via that are spaced apart, the first electrode is in contact with the channel layer through the first via, and the second electrode is in contact with the channel layer through the second via.

For another example, the transistor is a top-gate transistor. The channel layer, the first gate dielectric layer, the second gate dielectric layer, and the gate are sequentially stacked in a direction from the substrate to the transistor. The first gate dielectric layer and the second gate dielectric layer are groove-shaped, and the gate is disposed in the groove. The first electrode and the second electrode are disposed on the channel layer and are located on two opposite sides of a side wall of the groove.

For another example, the transistor is a vertical transistor. The first electrode and the gate are sequentially stacked in a direction from the substrate to the transistor. The gate includes a hollow part, and the second gate dielectric layer, the first gate dielectric layer, and the channel layer are sequentially stacked in a direction away from a side wall of the hollow part. The second electrode is disposed on a side that is of the channel layer and that faces away from the first electrode.

In this case, the chip further includes an insulating layer, and the second gate dielectric layer, the first gate dielectric layer, the channel layer, and the insulating layer are sequentially stacked in the direction away from the side wall of the hollow part. In other words, the insulating layer is disposed in an area enclosed by the channel. In this way, in this embodiment of this application, filling the insulating layer in the channel layer can decrease a thickness of the channel layer without changing a peripheral size of the channel layer, thereby improving gate controllability of the vertical transistor.

In addition, the first gate dielectric layer and the second gate dielectric layer include side walls and bottoms, and the bottom of the second gate dielectric layer is in contact with the first electrode. A third via is provided in the bottoms of the second gate dielectric layer and the first gate dielectric layer, and the channel layer is in contact with the first electrode through the third via.

According to a second aspect, this application provides an electronic device, including a circuit board and the chip according to the first aspect. The chip is disposed on the circuit board.

Any one of the second aspect and the implementations of the second aspect respectively correspond to the first aspect and any one of the implementations of the first aspect. For technical effects corresponding to any one of the second aspect and the implementations of the second aspect, refer to technical effects corresponding to the first aspect and any one of the implementations of the first aspect. Details are not described herein again.

According to a third aspect, this application further provides a fabrication method for a chip. The chip includes a transistor. A fabrication method for the transistor includes: forming a channel layer, a first gate dielectric layer, a second gate dielectric layer, and a gate on a substrate. The channel layer, the first gate dielectric layer, the second gate dielectric layer, and the gate are sequentially stacked, and the channel layer is in contact with the first gate dielectric layer. A material of the channel layer includes an oxide semiconductor. A defect concentration of a material of the first gate dielectric layer is lower than a defect concentration of a material of the second gate dielectric layer, and a dielectric constant of the material of the second gate dielectric layer is greater than a dielectric constant of the material of the first gate dielectric layer.

In some possible implementations, a difference between a defect energy level of the material of the first gate dielectric layer and a conduction band electron of the channel layer is greater than a difference between a defect energy level of the material of the second gate dielectric layer and the conduction band electron of the channel layer; and/or hydrogen content in the material of the first gate dielectric layer is less than hydrogen content in the material of the second gate dielectric layer.

In some possible implementations, forming the channel layer, the first gate dielectric layer, the second gate dielectric layer, and the gate on the substrate includes: sequentially forming the gate, the second gate dielectric layer, the first gate dielectric layer, and the channel layer on the substrate. After forming the channel layer, the first gate dielectric layer, the second gate dielectric layer, and the gate on the substrate, the fabrication method further includes: forming a first protective layer on the channel layer, where the first protective layer includes a first via and a second via that are spaced apart; and forming a first electrode and a second electrode on the first protective layer, where the first electrode is in contact with the channel layer through the first via, and the second electrode is in contact with the channel layer through the second via.

In some possible implementations, forming the channel layer, the first gate dielectric layer, the second gate dielectric layer, and the gate on the substrate includes: sequentially forming a channel layer, a conductive layer, and a second protective layer on the substrate, where the second protective layer includes a fourth via; forming a fifth via in the conductive layer under protection of the second protective layer, to obtain a first electrode and a second electrode, and expose a surface of a side that is of the channel layer and that faces away from the substrate; and sequentially forming the first gate dielectric layer, the second gate dielectric layer, and the gate in the fourth via and the fifth via.

In some possible implementations, before forming the channel layer, the first gate dielectric layer, the second gate dielectric layer, and the gate on the substrate, the fabrication method includes: forming a first electrode on the substrate. Forming the channel layer, the first gate dielectric layer, the second gate dielectric layer, and the gate on the substrate includes: forming the gate on the first electrode, where the gate includes a hollow part, and the hollow part exposes a surface of a side that is of the first electrode and that faces away from the substrate; and sequentially forming the second gate dielectric layer, the first gate dielectric layer, and the channel layer in the hollow part in a direction away from a side wall of the hollow part, where the channel layer is in contact with the surface of the side that is of the first electrode and that faces away from the substrate. After forming the channel layer, the first gate dielectric layer, the second gate dielectric layer, and the gate on the substrate, the fabrication method further includes: forming a second electrode on a side that is of the channel layer and that faces away from the first electrode.

In some possible implementations, after sequentially forming the second gate dielectric layer, the first gate dielectric layer, and the channel layer in the hollow part in the direction away from the side wall of the hollow part, the fabrication method further includes: filling the hollow part with an insulating layer, where the insulating layer is located on a side that is of the channel layer and that faces away from the first gate dielectric layer.

In some possible implementations, sequentially forming the second gate dielectric layer, the first gate dielectric layer, and the channel layer in the hollow part in the direction away from the side wall of the hollow part includes: sequentially forming the second gate dielectric layer, the first gate dielectric layer, and a sacrificial layer in the hollow part in the direction away from the side wall of the hollow part, to protect a side wall of the first gate dielectric layer by using the sacrificial layer, where the first gate dielectric layer and the second gate dielectric layer include side walls and bottoms, the bottom of the second gate dielectric layer is in contact with the first electrode, and the sacrificial layer covers the side walls and the bottoms of the first gate dielectric layer and the second gate dielectric layer, and exposes a third via in the bottoms of the second gate dielectric layer and the first gate dielectric layer; and removing the sacrificial layer, and filling the hollow part with the channel layer, where the channel layer is in contact with the first electrode through the third via.

Any one of the third aspect and the implementations of the third aspect corresponds to any one of the first aspect and the implementations of the first aspect. For technical effects corresponding to any one of the third aspect and the implementations of the third aspect, refer to technical effects corresponding to any one of the first aspect and the implementations of the first aspect. Details are not described herein again.

### BRIEF DESCRIPTION OF DRAWINGS

FIG. 1 is a diagram of a structure of a transistor according to an embodiment of this application;
FIG. 2 is a diagram of a structure of a transistor according to an embodiment of this application;
FIG. 3 is a diagram of a structure of a transistor according to an embodiment of this application;
FIG. 4a is a diagram of a structure of a transistor according to an embodiment of this application;
FIG. 4b is a top view of a partial structure of a transistor according to an embodiment of this application;
FIG. 5 is a diagram of a structure of a transistor according to an embodiment of this application;
FIG. 6 is a flowchart of fabricating a transistor according to an embodiment of this application;
FIG. 7a is a diagram of a fabrication process of a transistor according to an embodiment of this application;
FIG. 7b is a diagram of a fabrication process of a transistor according to an embodiment of this application;
FIG. 7c is a diagram of a fabrication process of a transistor according to an embodiment of this application;
FIG. 8 is a flowchart of fabricating a transistor according to an embodiment of this application;
FIG. 9a is a diagram of a fabrication process of a transistor according to an embodiment of this application;
FIG. 9b is a diagram of a fabrication process of a transistor according to an embodiment of this application;
FIG. 9c is a diagram of a fabrication process of a transistor according to an embodiment of this application;
FIG. 9d is a diagram of a fabrication process of a transistor according to an embodiment of this application;
FIG. 10 is a flowchart of fabricating a transistor according to an embodiment of this application;
FIG. 11a is a diagram of a fabrication process of a transistor according to an embodiment of this application;
FIG. 11b is a diagram of a fabrication process of a transistor according to an embodiment of this application;
FIG. 11c is a diagram of a fabrication process of a transistor according to an embodiment of this application;
FIG. 11d is a diagram of a fabrication process of a transistor according to an embodiment of this application;
FIG. 12 is a diagram of a fabrication process of a transistor according to an embodiment of this application;
FIG. 13a is a diagram of a fabrication process of a transistor according to an embodiment of this application; and
FIG. 13b is a diagram of a fabrication process of a transistor according to an embodiment of this application.

### DESCRIPTION OF EMBODIMENTS

The following clearly and completely describes the technical solutions in embodiments of this application with reference to the accompanying drawings in embodiments of this application. It is clear that the described embodiments are some but not all of embodiments of this application. All other embodiments obtained by a person of ordinary skill in the art based on embodiments of this application without creative efforts shall fall within the protection scope of this application.

The term "and/or" in this specification describes only an association relationship for describing associated objects and represents that three relationships may exist. For example, A and/or B may represent the following three cases: Only A exists, both A and B exist, and only B exists.

In the specification and claims in embodiments of this application, the terms "first", "second", and so on are intended to distinguish between different objects but do not indicate a particular order of the objects. For example, a first target object, a second target object, and the like are used for distinguishing between different target objects, but are not used for describing a specific order of the target objects.

In addition, in embodiments of this application, the word "exemplary" or "for example" is used to represent giving an example, an illustration, or a description. Any embodiment or design scheme described as an "example" or "for example" in embodiments of this application should not be explained as being more preferred or having more advantages than another embodiment or design scheme. To be precise, use of the words such as "example" or "for example" is intended to present a relative concept in a specific manner.

In descriptions of embodiments of this application, unless otherwise stated, "a plurality of" means two or more than two. For example, a plurality of processing units mean two or more processing units, and a plurality of systems mean two or more systems.

An embodiment of this application provides an electronic device. The electronic device may be a device including a memory, for example, a consumer electronic product, a home electronic product, a vehicle-mounted electronic product, a financial terminal product, or a communication electronic product.

For example, the consumer electronic product is a mobile phone (mobile phone), a tablet computer (tablet computer), a notebook computer, a personal computer (personal computer, PC), a personal digital assistant (personal digital assistant, PDA), an intelligent wearable product (for example, a smartwatch or a smart band), a virtual reality (virtual reality, VR) terminal device, an augmented reality (augmented reality, AR) terminal device, or an uncrewed aerial vehicle. For example, the home electronic product is an intelligent lock, a television, a smart speaker, a refrigerator, and a robotic vacuum cleaner. For example, the vehicle-mounted electronic product is a vehicle-mounted navigator or a vehicle-mounted display. The financial terminal product is, for example, an automated teller machine (automated teller machine, ATM) or a terminal for self-help service handling. For example, the communication electronic product is a device including a transistor, for example, a communication device like a server, a memory, a radar, or a base station.

For ease of description, the following uses an example in which the electronic device is a mobile phone for description. The mobile phone may include a processor. The processor includes a logic circuit and a memory. The memory includes a storage array, a storage controller, a decoder, and the like. The logic circuit may read and write data in the storage array through the storage controller and the decoder. The memory includes the storage array, the storage array includes a storage unit, and the storage unit includes a transistor and a capacitor. Certainly, another device may also include a transistor. This is not limited in embodiments of this application.

As mentioned in the background, with the development of advanced integrated circuit technologies, new transistors can be fabricated in a back-end-of-line process, which is an effective approach to achieving chip miniaturization and improving chip performance. An oxide semiconductor transistor with a channel layer including an oxide semiconductor has advantages such as a low leakage current, high mobility, a high on/off ratio, a low processing temperature, and easy back-end-of-line integration, and therefore becomes one of the candidates for next-generation transistor technologies.

However, reliability issues represented by BTI remain a main problem for the oxide semiconductor transistor.

For a conventional silicon-based transistor, a drift of a threshold voltage of the transistor is caused by an interface defect between a channel layer and a gate dielectric layer, which is a main cause of BTI degradation of the conventional silicon-based transistor.

For an N-type oxide semiconductor transistor, a gate dielectric layer and an interface defect cause a positive drift of a threshold voltage of the oxide semiconductor transistor to increase. In a chip, hydrogen (H) diffusing into the oxide semiconductor transistor for electron doping also causes a negative drift of the threshold voltage of the oxide semiconductor transistor to increase. The positive drift and the negative drift of the threshold voltage are main causes of BTI degradation of the oxide semiconductor transistor.

To resolve the foregoing problem, in a related technology, an ultra-thin layer of silicon dioxide (SiO₂) is inserted between a channel layer and a gate dielectric layer as a barrier layer, to prevent the gate dielectric layer from capturing electrons of the channel layer. However, in this technology, a quantity of defects in the gate dielectric layer is not directly decreased. Consequently, blocking relying on only the barrier layer does not significantly improve device reliability.

In view of this, an embodiment of this application provides a chip. The chip includes a transistor disposed on a substrate, and the transistor includes a channel layer, a first gate dielectric layer, a second gate dielectric layer, and a gate. A material of the channel layer includes an oxide semiconductor, so that the transistor is an oxide semiconductor transistor (which is collectively referred to as a transistor in the following). In this application, a first gate dielectric layer with a lower defect concentration is added, to suppress a positive drift component of a threshold voltage, so as to alleviate BTI of the transistor.

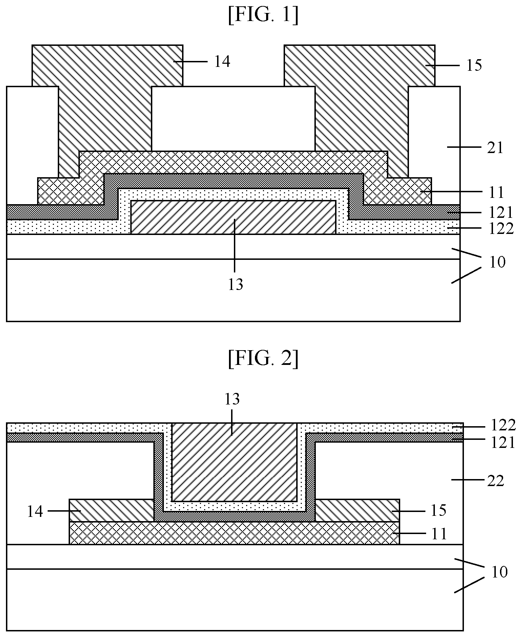

Specifically, as shown in FIG. 1 to FIG. 3, the channel layer 11, the first gate dielectric layer 121, the second gate dielectric layer 122, and the gate 13 are sequentially stacked. In one aspect, the channel layer 11 is in contact with the first gate dielectric layer 121, and a defect concentration of a material of the first gate dielectric layer 121 is lower than a defect concentration of a material of the second gate dielectric layer 122, that is, a quantity of defects of the first gate dielectric layer 121 is lower than a quantity of defects of the second gate dielectric layer 122, to suppress the positive drift component of the threshold voltage by using the first gate dielectric layer 121, so as to alleviate the BTI of the transistor. In another aspect, in addition to the first gate dielectric layer 121, the second gate dielectric layer 122 in contact with the gate 13 is further included in this embodiment of this application, and a dielectric constant of the material of the second gate dielectric layer 122 is greater than a dielectric constant of the material of the first gate dielectric layer 121, to ensure gate controllability of the gate 13 by using the second gate dielectric layer 122.

In some possible implementations, the material of the first gate dielectric layer 121 and the material of the second gate dielectric layer 122 are not limited in embodiments of this application, provided that the defect concentration of the material of the first gate dielectric layer 121 is lower than the defect concentration of the material of the second gate dielectric layer 122, and the dielectric constant of the material of the second gate dielectric layer 122 is greater than the dielectric constant of the material of the first gate dielectric layer 121.

In addition to the condition that the defect concentration of the material of the first gate dielectric layer 121 is lower than the defect concentration of the material of the second gate dielectric layer 122, and the dielectric constant of the material of the second gate dielectric layer 122 is greater than the dielectric constant of the material of the first gate dielectric layer 121, selection of the material of the first gate dielectric layer 121 and the material of the second gate dielectric layer 122 may further meet the following conditions:

For example, a difference between a defect energy level of the material of the first gate dielectric layer 121 and a conduction band electron of the channel layer 11 may be further greater than a difference between a defect energy level of the material of the second gate dielectric layer 122 and the conduction band electron of the channel layer 11, to suppress the positive drift component of the threshold voltage by using the first gate dielectric layer 121, so as to alleviate the BTI of the transistor; and/or, hydrogen content in the material of the first gate dielectric layer 121 is lower than hydrogen content in the material of the second gate dielectric layer 122, and because the content of the hydrogen in the first gate dielectric layer 121 is relatively small, only a small amount of hydrogen in the first gate dielectric layer 121 in contact with the channel layer 11 enters the channel layer 11 as a donor, and is doped with electrons in the channel layer 11, thereby effectively suppressing a negative drift component of the threshold voltage and alleviating the BTI of the transistor.

The content of the hydrogen in the material of the first gate dielectric layer 121 is not limited in embodiments of this application, provided that the content of the hydrogen in the material of the first gate dielectric layer 121 is lower than the content of the hydrogen in the material of the second gate dielectric layer 122. Optionally, the content of the hydrogen in the material of the first gate dielectric layer 121 may be less than 1e²⁰ atoms/cc (a quantity of atoms in a unit volume).

Optionally, the dielectric constant of the material of the second gate dielectric layer 122 is not limited in embodiments of this application, provided that the dielectric constant of the material of the second gate dielectric layer 122 is greater than the dielectric constant of the material of the first gate dielectric layer 121. Optionally, the dielectric constant of the material of the second gate dielectric layer 122 is greater than 15.

Based on the foregoing condition, the material of the first gate dielectric layer 121 may include at least one of aluminum oxide (Al₂O₃) and hafnium aluminum oxide (HfAlO). The material of the second gate dielectric layer 122 may include at least one of lanthanum oxide (La₂O₃) and hafnium dioxide (HfO₂).

In some possible implementations, as shown in FIG. 1, it is considered that the second gate dielectric layer 122 has a high defect concentration, a small difference with the conduction band electron of the channel layer 11, and a high hydrogen content, that is, the second gate dielectric layer 122 still has a large defect, which may affect the BTI of the transistor. Based on this, in a direction from the first gate dielectric layer 121 to the second gate dielectric layer 122, a thickness of the first gate dielectric layer 121 may be greater than a thickness of the second gate dielectric layer 122, so that the first gate dielectric layer 121 has a sufficient thickness to block the second gate dielectric layer 122, and the second gate dielectric layer 122 is prevented from capturing electrons in the channel layer 11, thereby alleviating the BTI of the transistor.

For example, the thickness of the first gate dielectric layer 121 may range from 2 nm to 50 nm, and the thickness of the second gate dielectric layer 122 is less than the thickness of the first gate dielectric layer 121. For example, the thickness of the first gate dielectric layer 121 is 3 nm, and the thickness of the second gate dielectric layer 122 is 2 nm.

In some possible implementations, a material of the channel layer 11 is not limited in embodiments of this application, provided that the material of the channel layer 11 includes an oxide semiconductor. For example, the material of the channel layer 11 includes an oxide semiconductor material like indium gallium zinc oxide (indium gallium zinc oxide, IGZO), indium gallium oxide, or indium zinc oxide.

In some possible implementations, as shown in FIG. 1 to FIG. 3, in addition to the channel layer 11, the first gate dielectric layer 121, the second gate dielectric layer 122, and the gate 13, the transistor further includes a first electrode 14 and a second electrode 15 that are in contact with the channel layer 11. The first electrode 14 is a source, and the second electrode 15 is a drain; or the first electrode 14 is a drain, and the second electrode 15 is a source.

For transistors of different structures, the channel layer 11, the first gate dielectric layer 121, the second gate dielectric layer 122, and the gate 13 are stacked at different positions.

For example, the transistor shown in FIG. 1 is a bottom-gate transistor. The transistor further includes a first protective layer 21. The gate 13, the second gate dielectric layer 122, the first gate dielectric layer 121, the channel layer 11, and the first protective layer 21 are sequentially stacked in a direction from the substrate 10 to the transistor. Both the first electrode and the second electrode are disposed on a side that is of the first protective layer 21 and that faces away from the substrate 10. The first protective layer 21 includes a first via and a second via that are spaced apart, the first electrode 14 is in contact with the channel layer 11 through the first via, and the second electrode 15 is in contact with the channel layer 11 through the second via.

For another example, the transistor shown in FIG. 2 is a top-gate transistor. The channel layer 11, the first gate dielectric layer 121, the second gate dielectric layer 122, and the gate 13 are sequentially stacked in a direction from the substrate 10 to the transistor. The first gate dielectric layer 121 and the second gate dielectric layer 122 are groove-shaped, and the gate 13 is disposed in the groove. The first electrode 14 and the second electrode 15 are disposed on the channel layer 11, are in contact with the channel layer 11, and are located on two opposite sides of a side wall of the groove, so that the first electrode 14 and the second electrode 15 are electrically isolated from the gate 13 by using the first gate dielectric layer 121 and the second gate dielectric layer 122.

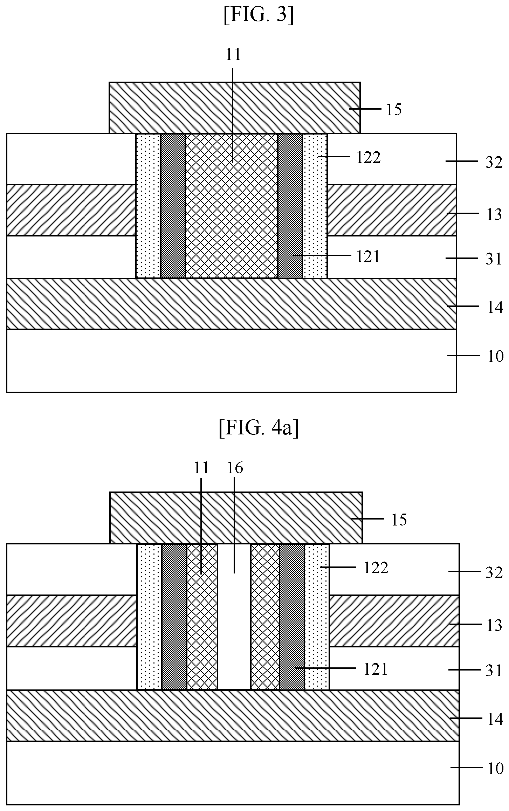

For another example, the transistor shown in FIG. 3 is a vertical transistor. The first electrode 14 and the gate 13 are sequentially stacked in a direction from the substrate 10 to the transistor. The gate 13 includes a hollow part, and the second gate dielectric layer 122, the first gate dielectric layer 121, and the channel layer 11 are sequentially stacked in a direction away from a side wall of the hollow part. In addition, the second electrode 15 is disposed on a side that is of the channel layer 11 and that faces away from the first electrode 14, that is, in the direction from the substrate 10 to the transistor, the first electrode 14 and the second electrode 15 are separately disposed on two opposite sides of the channel layer 11.

A first dielectric layer 31 is further disposed between the first electrode 14 and the gate 13, and a second dielectric layer 32 is further disposed between the second electrode 15 and the gate 13. In one aspect, the first dielectric layer 31 is used to electrically isolate the first electrode 14 from the gate 13, and the second dielectric layer 32 is used to electrically isolate the second electrode 15 from the gate 13. In another aspect, the first dielectric layer 31 and the second dielectric layer 32 are further used to define a gate length (gate length) of the gate 13. It should be understood that, in this application, a gate length direction of the gate 13 is a direction from the first electrode 14 to the second electrode 15.

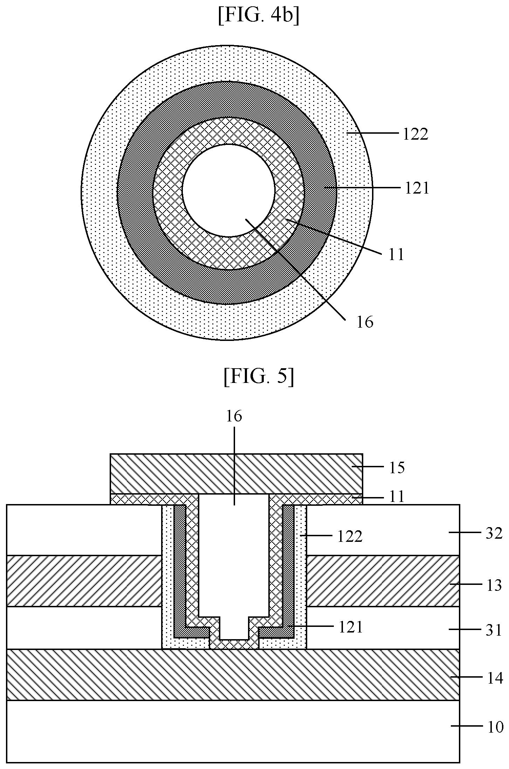

Based on the vertical transistor shown in FIG. 3, as shown in FIG. 4a and FIG. 4b, the chip may further include an insulating layer 16, and the second gate dielectric layer 122, the first gate dielectric layer 121, the channel layer 11, and the insulating layer 16 are sequentially stacked in the direction away from the side wall of the hollow part. In other words, the insulating layer 16 is disposed in an area enclosed by the channel 11. In this way, in this embodiment of this application, filling the insulating layer 16 in the channel layer 11 can decrease a thickness of the channel layer 11 without changing a peripheral size of the channel layer 11, thereby improving gate controllability of the vertical transistor.

It should be understood that a thickness direction of the channel layer 11 is a direction from a side wall of the first gate dielectric layer 121 to a side wall of the second gate dielectric layer 122.

Further, based on the vertical transistor shown in FIG. 3 or FIG. 4a, as shown in FIG. 5, the first gate dielectric layer 121 and the second gate dielectric layer 122 further include bottoms adjacent to the side walls, and the bottom of the second gate dielectric layer 122 is in contact with the first electrode 11. A third via is provided in the bottoms of the second gate dielectric layer 122 and the first gate dielectric layer 121, and the channel layer 11 is in contact with the first electrode 14 through the third via.

Certainly, the transistor may alternatively be of another structure. This is not limited in embodiments of this application, provided that the first gate dielectric layer 121 and the second gate dielectric layer 122 are disposed between the channel layer 11 and the gate 13, the first gate dielectric layer 121 is disposed on a side of the second gate dielectric layer 122 facing the channel layer 11, and the second gate dielectric layer 122 is disposed on a side of the first gate dielectric layer 121 facing the gate 13.

In another embodiment, this application further provides a fabrication method for a chip. The chip includes a transistor. A fabrication method for the transistor includes: forming a channel layer 11, a first gate dielectric layer 121, a second gate dielectric layer 122, and a first gate dielectric layer gate 13 on a substrate 10. The channel layer 11, the first gate dielectric layer 121, the second gate dielectric layer 122, and the first gate dielectric layer gate 13 are sequentially stacked. A material of the channel layer 11 includes an oxide semiconductor. A defect concentration of a material of the first gate dielectric layer 121 is lower than a defect concentration of a material of the second gate dielectric layer 11, and a dielectric constant of the material of the second gate dielectric layer 122 is greater than a dielectric constant of the material of the first gate dielectric layer 121.

In one aspect, the defect concentration of the material of the first gate dielectric layer 121 is lower than the defect concentration of the material of the second gate dielectric layer 122, that is, a quantity of defects of the first gate dielectric layer 121 in contact with the channel layer 11 is lower than a quantity of defects of the second gate dielectric layer 122, to suppress a positive drift component of a threshold voltage by using the first gate dielectric layer 121, so as to alleviate BTI of the transistor. In another aspect, the dielectric constant of the material of the first gate dielectric layer 121 with a low defect concentration is usually low. However, if the dielectric constant of the first gate dielectric layer 121 decreases, gate controllability of the gate 13 is affected. Therefore, in addition to the first gate dielectric layer 121, the second gate dielectric layer 122 in contact with the gate 13 is further included in this embodiment of this application, and the dielectric constant of the material of the second gate dielectric layer 122 is greater than the dielectric constant of the material of the first gate dielectric layer 121, to ensure the gate controllability of the gate 13 by using the second gate dielectric layer 122.

In some possible implementations, the material of the first gate dielectric layer 121 and the material of the second gate dielectric layer 122 are not limited in embodiments of this application, provided that the defect concentration of the material of the first gate dielectric layer 121 is lower than the defect concentration of the material of the second gate dielectric layer 122, and the dielectric constant of the material of the second gate dielectric layer 122 is greater than the dielectric constant of the material of the first gate dielectric layer 121.

In addition to the condition that the defect concentration of the material of the first gate dielectric layer 121 is lower than the defect concentration of the material of the second gate dielectric layer 122, and the dielectric constant of the material of the second gate dielectric layer 122 is greater than the dielectric constant of the material of the first gate dielectric layer 121, selection of the material of the first gate dielectric layer 121 and the material of the second gate dielectric layer 122 may further meet the following conditions:

For example, a difference between a defect energy level of the material of the first gate dielectric layer 121 and a conduction band electron of the channel layer 11 may be further greater than a difference between a defect energy level of the material of the second gate dielectric layer 122 and the conduction band electron of the channel layer 11, to suppress the positive drift component of the threshold voltage by using the first gate dielectric layer 121, so as to alleviate the BTI of the transistor; and/or, hydrogen content in the material of the first gate dielectric layer 121 is lower than hydrogen content in the material of the second gate dielectric layer 122, and because the content of the hydrogen in the first gate dielectric layer 121 is relatively small, only a small amount of hydrogen in the first gate dielectric layer 121 in contact with the channel layer 11 enters the channel layer 11 as a donor, and is doped with electrons in the channel layer 11, thereby effectively suppressing a negative drift component of the threshold voltage and alleviating the BTI of the transistor.

The content of the hydrogen in the material of the first gate dielectric layer 121 is not limited in embodiments of this application, provided that the content of the hydrogen in the material of the first gate dielectric layer 121 is lower than the content of the hydrogen in the material of the second gate dielectric layer 122. Optionally, the content of the hydrogen in the material of the first gate dielectric layer 121 may be less than 1e²⁰ atoms/cc (a quantity of atoms in a unit volume).

Optionally, the dielectric constant of the material of the second gate dielectric layer 122 is not limited in embodiments of this application, provided that the dielectric constant of the material of the second gate dielectric layer 122 is greater than the dielectric constant of the material of the first gate dielectric layer 121. Optionally, the dielectric constant of the second gate dielectric layer 122 is greater than 15.

Based on the foregoing condition, the material of the first gate dielectric layer 121 may include at least one of Al₂O₃ and HfAlO. The material of the second gate dielectric layer 122 may include at least one of La₂O₃ and HfO₂.

In some possible implementations, as shown in FIG. 1, it is considered that the second gate dielectric layer 122 has a high defect concentration, a small difference with the conduction band electron of the channel layer 11, and a high hydrogen content, that is, the second gate dielectric layer 122 still has a large defect, which may affect the BTI of the transistor. Based on this, in a direction from the first gate dielectric layer 121 to the second gate dielectric layer 122, a thickness of the first gate dielectric layer 121 may be greater than a thickness of the second gate dielectric layer 122, so that the first gate dielectric layer 121 has a sufficient thickness to block the second gate dielectric layer 122, and the second gate dielectric layer 122 is prevented from capturing electrons in the channel layer 11, thereby alleviating the BTI of the transistor.

For example, the thickness of the first gate dielectric layer 121 may range from 2 nm to 50 nm, and the thickness of the second gate dielectric layer 122 is less than the thickness of the first gate dielectric layer 121. For example, the thickness of the first gate dielectric layer 121 is 3 nm, and the thickness of the second gate dielectric layer 122 is 2 nm.

In some possible implementations, as shown in FIG. 1 to FIG. 3, in addition to the channel layer 11, the first gate dielectric layer 121, the second gate dielectric layer 122, and the gate 13, the transistor further includes a first electrode 14 and a second electrode 15 that are in contact with the channel layer 11. The first electrode 14 is a source, and the second electrode 15 is a drain; or the first electrode 14 is a drain, and the second electrode 15 is a source.

For transistors of different structures, fabrication processes of the transistors are different. The following describes fabrication processes of the following three transistors with reference to the accompanying drawings.

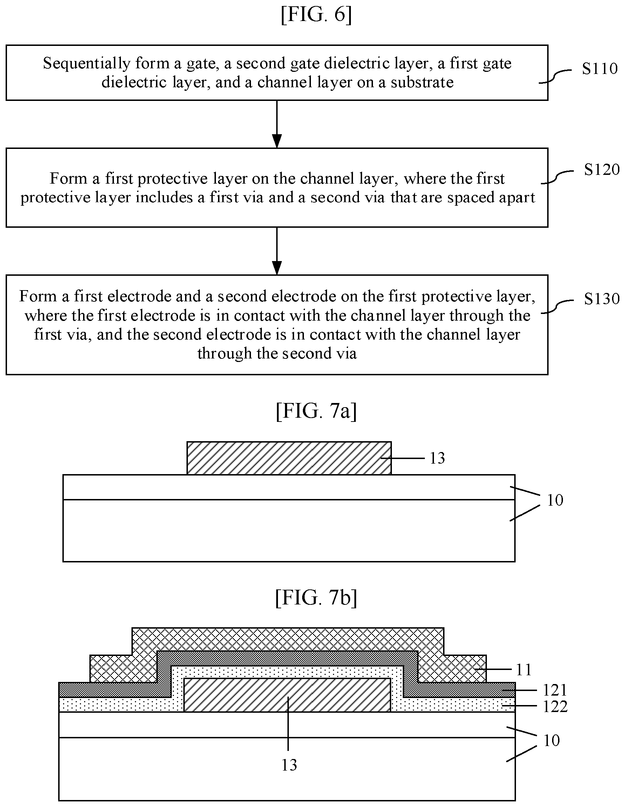

A first type of transistor is a bottom-gate transistor. As shown in FIG. 6, the transistor may be implemented by using the following steps.

S110: As shown in FIG. 7a and FIG. 7b, sequentially form a gate 13, a second gate dielectric layer 122, a first gate dielectric layer 121, and a channel layer 11 on a substrate 10.

In some possible implementations, a material of the substrate 10 is not limited in embodiments of this application. Optionally, a laminated layer of silicon and silicon dioxide may be used as the substrate 10. Certainly, the material of the substrate 10 may further include another material that can be used for oxide semiconductor deposition, such as glass.

In some possible implementations, a material of the gate 13 is not limited in embodiments of this application, provided that the gate 13 can be conductive. Optionally, the gate 13 may include tungsten, titanium nitride, nickel, indium tin oxide, and the like.

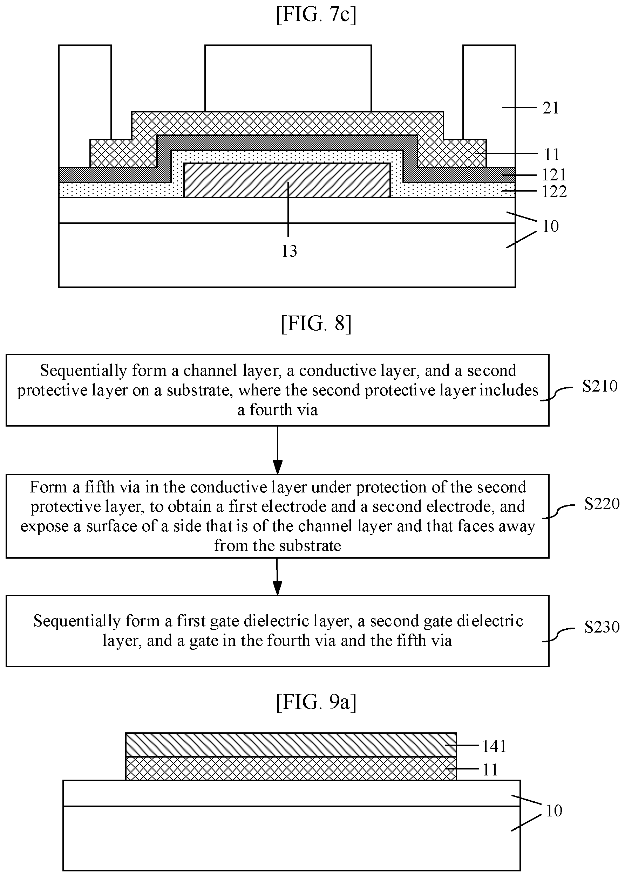

S120: As shown in FIG. 7c, form a first protective layer 21 on the channel layer 11, where the first protective layer 21 includes a first via and a second via that are spaced apart.

In some possible implementations, a material of the first protective layer 21 may include a material that has an isolation effect, such as silicon dioxide, aluminum oxide, and hafnium oxide.

S130: As shown in FIG. 1, form a first electrode 14 and a second electrode 15 on the first protective layer 21, where the first electrode 14 is in contact with the channel layer 11 through the first via, and the second electrode 15 is in contact with the channel layer 11 through the second via.

In some possible implementations, the material of the first electrode 14 and the material of the second electrode 15 may be the same, and both include conductive materials such as tungsten, titanium nitride, nickel, and indium tin oxide.

A second type of transistor is a top-gate transistor. As shown in FIG. 8, the transistor may be implemented by using the following steps.

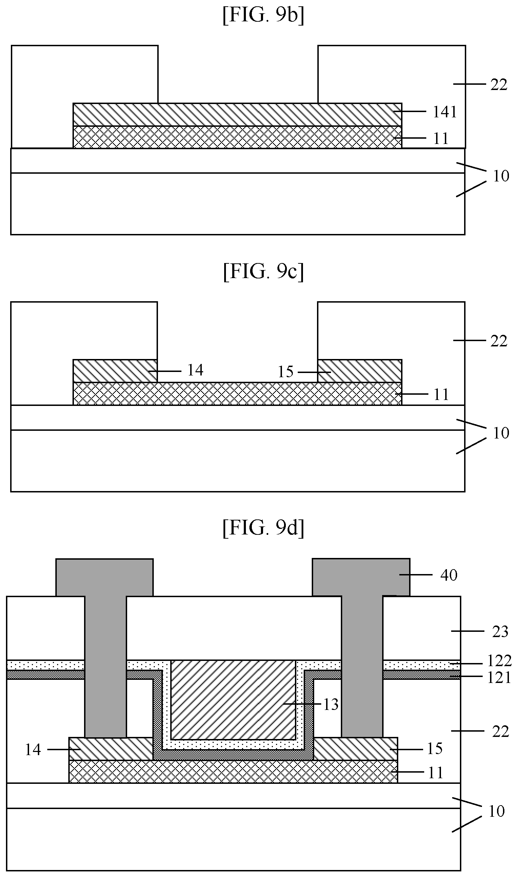

S210: As shown in FIG. 9a to FIG. 9b, sequentially form a channel layer 11, a conductive layer 141, and a second protective layer 22 on a substrate 10. The second protective layer 22 includes a fourth via.

In some possible implementations, a material of the substrate 10 is not limited in embodiments of this application. Optionally, a laminated layer of silicon and silicon dioxide may be used as the substrate 10. Certainly, the material of the substrate 10 may further include another material that can be used for oxide semiconductor deposition, such as glass.

In some possible implementations, a material of the conductive layer 141 is not limited in embodiments of this application. Optionally, the material of the conductive layer 141 may include a conductive material such as tungsten, titanium nitride, nickel, and indium tin oxide.

S220: As shown in FIG. 9c, form a fifth via in the conductive layer 141 under protection of the second protective layer 22, to obtain a first electrode 14 and a second electrode 15, and expose a surface of a side that is of the channel layer 11 and that faces away from the substrate 10.

In some possible implementations, a material of the second protective layer 22 may include a material that has an isolation effect, such as silicon dioxide, aluminum oxide, and hafnium oxide.

S230: As shown in FIG. 2, sequentially form a first gate dielectric layer 121, a second gate dielectric layer 122, and a gate 13 in the fourth via and the fifth via. In this way, the first gate dielectric layer 121 may be in contact with the channel layer 11.

In some possible implementations, a material of the gate 13 is not limited in embodiments of this application, provided that the gate 13 can be conductive. Optionally, the gate 13 may include tungsten, titanium nitride, nickel, indium tin oxide, and the like.

In addition, as shown in FIG. 9d, after the gate 13 is formed, the fabrication method for the transistor may further include: sequentially forming a third protective layer 23 and conductive leads 40 on a side that is of the gate 13 and that faces away from the substrate 10, and the conductive leads 40 are electrically connected to the first electrode 14 and the second electrode 15 respectively through vias in the third protective layer 23, the second protective layer 22, and the like.

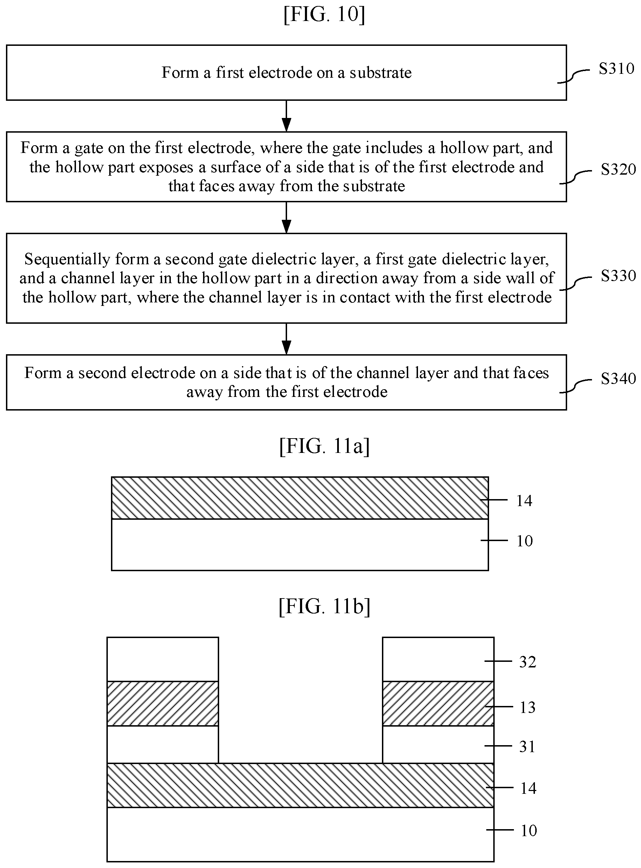

A third type of the transistor is a vertical transistor. As shown in FIG. 10, the transistor may be implemented by using the following steps.

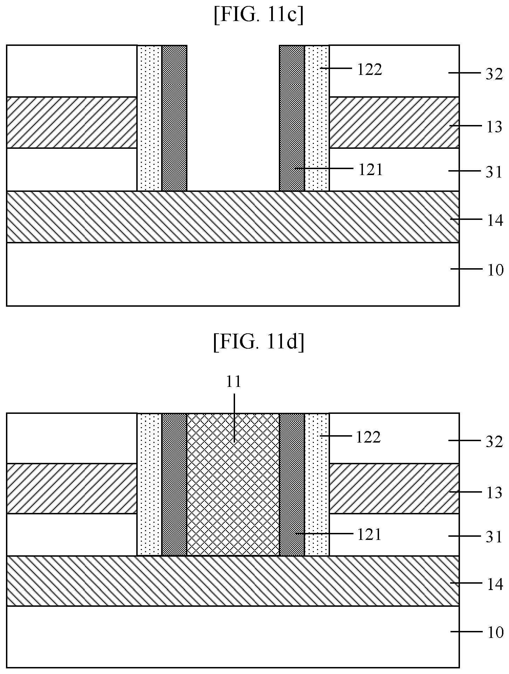

S310: As shown in FIG. 11a, form a first electrode 14 on a substrate 10.

In some possible implementations, a material of the substrate 10 is not limited in embodiments of this application. Optionally, a laminated layer of silicon and silicon dioxide may be used as the substrate 10. Certainly, the material of the substrate 10 may further include another material that can be used for oxide semiconductor deposition, such as glass.

S320: As shown in FIG. 11b, form a gate 13 on the first electrode 14, where the gate 13 includes a hollow part, and the hollow part exposes a surface of a side that is of the first electrode 14 and that faces away from the substrate 10.

In some possible implementations, a first dielectric layer 31 is further disposed between the first electrode 14 and the gate 13. In one aspect, the first dielectric layer 31 is used to electrically isolate the first electrode 14 from the gate 13. In another aspect, the first dielectric layer 31 is further used to define a gate length of the gate 13.

In some possible implementations, a material of the gate 13 is not limited in embodiments of this application, provided that the gate 13 can be conductive. Optionally, the gate 13 may include tungsten, titanium nitride, nickel, indium tin oxide, and the like.

S330: As shown in FIG. 11c to FIG. 11d, sequentially form a second gate dielectric layer 122, a first gate dielectric layer 121, and a channel layer 11 in the hollow part in a direction away from a side wall of the hollow part. The channel layer 11 is in contact with the first electrode 14.

S340: As shown in FIG. 3, form a second electrode 15 on a side that is of the channel layer 11 and that faces away from the first electrode 14.

In some possible implementations, a second dielectric layer 32 is further disposed between the second electrode 15 and the gate 13. In one aspect, the second dielectric layer 32 is used to electrically isolate the second electrode 15 from the gate 13. In another aspect, the second dielectric layer 32 is further used to define a gate length of the gate 13.

In some possible implementations, a material of the first electrode 14 and a material of the second electrode 15 may be the same, and both include conductive materials such as tungsten, titanium nitride, nickel, and indium tin oxide.

In some embodiments, there are other structural variations in the third case.

In a first variation structure, a fabrication process includes the following steps.

S310: As shown in FIG. 11a, form a first electrode 14 on a substrate 10.

S320: As shown in FIG. 11b, form a gate 13 on the first electrode 14, where the gate 13 includes a hollow part, and the hollow part exposes a surface of a side that is of the first electrode 14 and that faces away from the substrate 10.

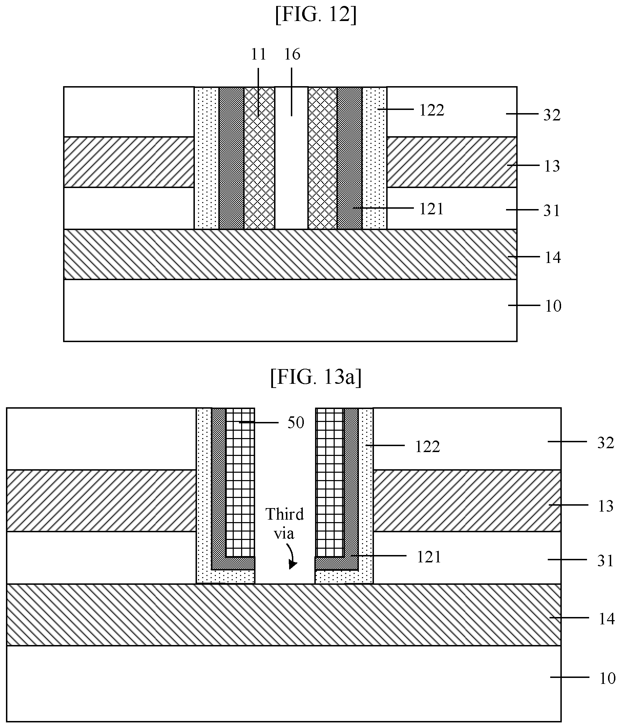

S331: As shown in FIG. 12, sequentially form a second gate dielectric layer 122, a first gate dielectric layer 121, a channel layer 11, and an insulating layer 16 in the hollow part in a direction away from a side wall of the hollow part. In other words, the insulating layer 16 is disposed in an area enclosed by the channel 11. In this way, in this embodiment of this application, filling the insulating layer 16 in the channel layer 11 can decrease a thickness of the channel layer 11 without changing a peripheral size of the channel layer 11, thereby improving gate controllability of the vertical transistor. The channel layer 11 is in contact with the first electrode 14.

S340: As shown in FIG. 4a, form a second electrode 15 on a side that is of the channel layer 11 and that faces away from the first electrode 14.

In a second variation structure, a fabrication process includes the following steps.

S310: As shown in FIG. 11a, form a first electrode 14 on a substrate 10.

S320: As shown in FIG. 11b, form a gate 13 on the first electrode 14, where the gate 13 includes a hollow part, and the hollow part exposes a surface of a side that is of the first electrode 14 and that faces away from the substrate 10.

S332: As shown in FIG. 13a, sequentially form a second gate dielectric layer 122, a first gate dielectric layer 121, and a sacrificial layer 50 in the hollow part in a direction away from a side wall of the hollow part, to protect a side wall of the first gate dielectric layer 121 by using the sacrificial layer 50. The first gate dielectric layer 121 and the second gate dielectric layer 122 include side walls and bottoms, and the bottom of the second gate dielectric layer 122 is in contact with the first electrode 14. The sacrificial layer 50 covers the side walls and the bottoms of the first gate dielectric layer 121 and the second gate dielectric layer 122, and exposes a third via in the bottoms of the second gate dielectric layer 122 and the first gate dielectric layer 121.

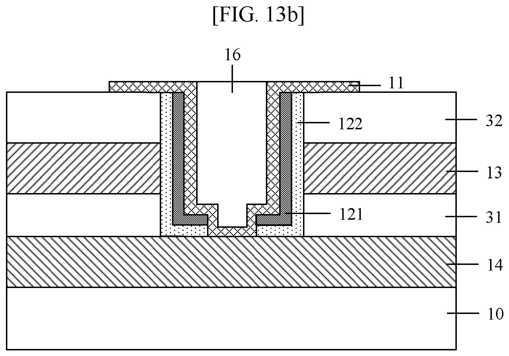

S333: As shown in FIG. 13b, remove the sacrificial layer 50, and fill the hollow part with a channel layer 11, where the channel layer 11 is in contact with the first electrode 14 through the third via.

On this basis, as shown in FIG. 13b, after the channel layer 11 is formed, the hollow part may be further filled with an insulating layer 16. In other words, the insulating layer 16 is disposed in an area enclosed by the channel 11. In this way, in this embodiment of this application, filling the insulating layer 16 in the channel layer 11 can decrease a thickness of the channel layer 11 without changing a peripheral size of the channel layer 11, thereby improving gate controllability of the vertical transistor.

S340: As shown in FIG. 5, form a second electrode 15 on a side that is of the channel layer 11 and that faces away from the first electrode 14.

In addition, other explanations, descriptions, and beneficial effects of embodiments of this application are the same as those of the previous embodiment. Details are not described herein again.

The foregoing describes embodiments of this application with reference to the accompanying drawings. However, this application is not limited to the foregoing specific implementations. The foregoing specific implementations are merely non-limiting examples. In light of the teachings of this application, a person of ordinary skill in the art may further make many modifications without departing from the purposes of this application and the protection scope of the claims, and all the modifications shall fall within the protection of this application.

## Claims

1. A chip, comprising a transistor, wherein the transistor comprises a channel layer, a first gate dielectric layer, a second gate dielectric layer, and a gate that are sequentially stacked; and
a material of the channel layer comprises an oxide semiconductor, and the channel layer is in contact with the first gate dielectric layer; and a defect concentration of a material of the first gate dielectric layer is lower than a defect concentration of a material of the second gate dielectric layer, and a dielectric constant of the material of the second gate dielectric layer is greater than a dielectric constant of the material of the first gate dielectric layer.

2. The chip according to claim 1, wherein a difference between a defect energy level of the material of the first gate dielectric layer and a conduction band electron of the channel layer is greater than a difference between a defect energy level of the material of the second gate dielectric layer and the conduction band electron of the channel layer; and/or hydrogen content in the material of the first gate dielectric layer is less than hydrogen content in the material of the second gate dielectric layer.

3. The chip according to claim 2, wherein the content of the hydrogen in the material of the first gate dielectric layer is less than 1e20 atoms/cc.

4. The chip according to any one of claims 1 to 3, wherein the material of the first gate dielectric layer comprises hafnium aluminum oxide and aluminum oxide; and/or the dielectric constant of the second gate dielectric layer is greater than 15.

5. The chip according to any one of claims 1 to 4, wherein in a direction from the first gate dielectric layer to the second gate dielectric layer, a thickness of the first gate dielectric layer is greater than a thickness of the second gate dielectric layer.

6. The chip according to any one of claims 1 to 5, wherein the chip further comprises a substrate, and the transistor is disposed on the substrate; and
the transistor further comprises a first electrode and a second electrode, and both the first electrode and the second electrode are in contact with the channel.

7. The chip according to claim 6, wherein
the gate, the second gate dielectric layer, the first gate dielectric layer, and the channel layer are sequentially stacked in a direction from the substrate to the transistor;
the transistor further comprises a first protective layer, wherein the first protective layer, the first electrode, and the second electrode are all disposed on a side that is of the channel layer and that faces away from the substrate, and the first protective layer is disposed between the channel layer, and the first electrode and the second electrode; and
the first protective layer comprises a first via and a second via that are spaced apart, the first electrode is in contact with the channel layer through the first via, and the second electrode is in contact with the channel layer through the second via.

8. The chip according to claim 6, wherein
the channel layer, the first gate dielectric layer, the second gate dielectric layer, and the gate are sequentially stacked in a direction from the substrate to the transistor; and
the first gate dielectric layer and the second gate dielectric layer are groove-shaped, and the gate is disposed in the groove; and the first electrode and the second electrode are disposed on the channel layer and are located on two opposite sides of a side wall of the groove.

9. The chip according to claim 6, wherein the first electrode and the gate are sequentially stacked in a direction from the substrate to the transistor; and
the gate comprises a hollow part, and the second gate dielectric layer, the first gate dielectric layer, and the channel layer are sequentially stacked in a direction away from a side wall of the hollow part; and the second electrode is disposed on a side that is of the channel layer and that faces away from the first electrode.

10. The chip according to claim 6, wherein the chip further comprises an insulating layer, and the second gate dielectric layer, the first gate dielectric layer, the channel layer, and the insulating layer are sequentially stacked in a direction away from a side wall of the hollow part.

11. The chip according to claim 9 or 10, wherein the first gate dielectric layer and the second gate dielectric layer comprise side walls and bottoms, and the bottom of the second gate dielectric layer is in contact with the first electrode; and
a third via is provided in the bottoms of the second gate dielectric layer and the first gate dielectric layer, and the channel layer is in contact with the first electrode through the third via.

12. An electronic device, comprising a circuit board and the chip according to any one of claims 1 to 11, wherein the chip is disposed on the circuit board.

13. A fabrication method for a chip, wherein the chip comprises a transistor, and a fabrication method for the transistor comprises:
forming a channel layer, a first gate dielectric layer, a second gate dielectric layer, and a gate on a substrate, wherein the channel layer, the first gate dielectric layer, the second gate dielectric layer, and the gate are sequentially stacked, and the channel layer is in contact with the first gate dielectric layer; a material of the channel layer comprises an oxide semiconductor; and a defect concentration of a material of the first gate dielectric layer is lower than a defect concentration of a material of the second gate dielectric layer, and a dielectric constant of the material of the second gate dielectric layer is greater than a dielectric constant of the material of the first gate dielectric layer.

14. The fabrication method according to claim 13, wherein a difference between a defect energy level of the material of the first gate dielectric layer and a conduction band electron of the channel layer is greater than a difference between a defect energy level of the material of the second gate dielectric layer and the conduction band electron of the channel layer; and/or
hydrogen content in the material of the first gate dielectric layer is less than hydrogen content in the material of the second gate dielectric layer.

15. The fabrication method according to claim 13 or 14, wherein forming the channel layer, the first gate dielectric layer, the second gate dielectric layer, and the gate on the substrate comprises:
sequentially forming the gate, the second gate dielectric layer, the first gate dielectric layer, and the channel layer on the substrate; and
after forming the channel layer, the first gate dielectric layer, the second gate dielectric layer, and the gate on the substrate, the fabrication method further comprises:
forming a first protective layer on the channel layer, wherein the first protective layer comprises a first via and a second via that are spaced apart; and
forming a first electrode and a second electrode on the first protective layer, wherein the first electrode is in contact with the channel layer through the first via, and the second electrode is in contact with the channel layer through the second via.

16. The fabrication method according to claim 13 or 14, wherein forming the channel layer, the first gate dielectric layer, the second gate dielectric layer, and the gate on the substrate comprises:
sequentially forming the channel layer, a conductive layer, and a second protective layer on the substrate, wherein the second protective layer comprises a fourth via;
forming a fifth via in the conductive layer under protection of the second protective layer, to obtain a first electrode and a second electrode, and expose a surface of a side that is of the channel layer and that faces away from the substrate; and
sequentially forming the first gate dielectric layer, the second gate dielectric layer, and the gate in the fourth via and the fifth via.

17. The fabrication method according to claim 13 or 14, wherein before forming the channel layer, the first gate dielectric layer, the second gate dielectric layer, and the gate on the substrate, the fabrication method comprises:
forming a first electrode on the substrate;
forming the channel layer, the first gate dielectric layer, the second gate dielectric layer, and the gate on the substrate comprises:
forming the gate on the first electrode, wherein the gate comprises a hollow part, and the hollow part exposes a surface of a side that is of the first electrode and that faces away from the substrate; and
sequentially forming the second gate dielectric layer, the first gate dielectric layer, and the channel layer in the hollow part in a direction away from a side wall of the hollow part, wherein the channel layer is in contact with the surface of the side that is of the first electrode and that faces away from the substrate; and
after forming the channel layer, the first gate dielectric layer, the second gate dielectric layer, and the gate on the substrate, the fabrication method further comprises:
forming a second electrode on a side that is of the channel layer and that faces away from the first electrode.

18. The fabrication method according to claim 17, wherein after sequentially forming the second gate dielectric layer, the first gate dielectric layer, and the channel layer in the hollow part in the direction away from the side wall of the hollow part, the fabrication method further comprises:
filling the hollow part with an insulating layer, wherein the insulating layer is located on a side that is of the channel layer and that faces away from the first gate dielectric layer.

19. The fabrication method according to claim 17 or 18, wherein sequentially forming the second gate dielectric layer, the first gate dielectric layer, and the channel layer in the hollow part in the direction away from the side wall of the hollow part comprises:
sequentially forming the second gate dielectric layer, the first gate dielectric layer, and a sacrificial layer in the hollow part in the direction away from the side wall of the hollow part, wherein the first gate dielectric layer and the second gate dielectric layer comprise side walls and bottoms, and the bottom of the second gate dielectric layer is in contact with the first electrode; and the sacrificial layer covers the side walls and the bottoms of the first gate dielectric layer and the second gate dielectric layer, and exposes a third via in the bottoms of the second gate dielectric layer and the first gate dielectric layer; and
removing the sacrificial layer, and filling the hollow part with the channel layer, wherein the channel layer is in contact with the first electrode through the third via.
